# EUROPÄISCHE PATENTSCHRIFT

(11) **EP 0 639 309 B1**
(45) Veröffentlichungstag und Bekanntmachung des Hinweises auf die Patenterteilung: **27.12.1996**
(21) Anmeldenummer: 93911426.0
(22) Anmeldetag: 30.04.1993
(51) Int. Cl.: H03K 19/096

(54) **ASYNCHRONE LOGIKSCHALTUNG FÜR DEN 2-PHASEN-BETRIEB**
ASYNCHRONOUS LOGIC CIRCUIT FOR 2-PHASE OPERATION
CIRCUIT LOGIQUE ASYNCHRONE POUR LE FONCTIONNEMENT DIPHASE

(30) Priorität: 06.05.1992 DE 4214981
(43) Veröffentlichungstag der Anmeldung: 22.02.1995
(73) Patentinhaber: SIEMENS AKTIENGESELLSCHAFT, 80333 München (DE)
(72) Erfinder: KNAUER, Karl, D-8018 Grafing (DE)
(86) Internationale Anmeldenummer: DE9300380
(87) Internationale Veröffentlichungsnummer: WO9322838

(56) Entgegenhaltungen:
- WO-A-92/20156
- ELECTRONICS LETTERS Bd. 25, Nr. 3, 2. Februar 1989, STEVENAGE,HERTS.,(GB) Seiten 215 - 217 PATEL ET AL 'evaluation of self-timed systems for vlsi'
- ELECTRONICS LETTERS Bd. 23, Nr. 6, 12. M rz 1987, STEVENAGE,HERTS.,(GB) Seiten 269 - 270 LAU 'self:a self -timed systems design technique'

## Beschreibung

Die Erfindung betrifft eine asynchrone Logikschaltung für den 2-Phasen-Betrieb.

Eine Logikschaltung dieser Art ist beispielsweise in der beim Deutschen Patentamt eingereichten Patentanmeldung mit dem amtlichen Kennzeichen P 41 15 081.3 (= GR 91 P 1239 DE) wiedergegeben und stellt einen Stand der Technik im Sinne von PatG § 3 (2)/EPÜ Art. 54 (3) dar. Dabei handelt es sich um eine Logikschaltung, bei der eine Mehrzahl von Eingangsleitungen sowohl mit einem Logikblock aus n-Kanal-Feldeffekttransistoren als auch mit einem dazu inversen Logikblock aus p-Kanal-Transistoren verbunden ist (Split Transistor Switch Logic), bei der beide Blöcke sowohl jeweils mit einem Vorladetransistor und einem Ladetransistor verbunden sind und bei der die mit dem ersten Block verbundenen Transistoren direkt und die mit dem anderen Logikblock verbundenen Transistoren indirekt über einen Inverter durch ein Anfragesignal ansteuerbar sind, wobei in einem ersten Zustand (low) des Anfragesignals ein Vorladen und im zweiten Zustand (high) ein Laden bzw. eine Bwertung entsprechend der durch die Logikblocks vorgegebenen logischen Verknüpfung erfolgt.

Aus der europäischen Patentanmeldung mit der Veröffentlichungsnummer 0 147 598 ist ein getaktetes differentielles Kaskode-Spannungs-Schaltlogiksystem (CVS-Logiksystem) bekannt, bei dem eine erste Schalteinrichtung und eine zweite Schalteinrichtung vorgesehen sind, deren erste Ausgänge jeweils über Transistoren mit der Versorgungsspannung und deren zweite Ausgänge jeweils über Transistoren mit Bezugspotential verbunden sind, wobei die zweite Schalteinrichtung mit Eingangssignalen versorgt wird, die komplementär zu den Eingangssignalen der ersten Schalteinrichtung sind und wobei.die zweite Schalteinrichtung genau dann durchschaltet, wenn die erste Schaltungseinrichtung nicht durchschaltet und umgekehrt.

Der Erfindung liegt die Aufgabe zugrunde eine asynchrone Logikschaltung anzugeben, die im 2-Phasen-Betrieb (flankengesteuert) und nicht wie sonst üblich im 4-Phasen-Betrieb (zustandsgesteuert) betriebbar ist und die einen möglichst geringen Schaltungsaufwand erfordert.

Diese Aufgabe wird erfindungsgemäß durch die im Patentanspruch 1 angegebenen Merkmale gelöst.

Die Patentansprüche 2 und 3 sind auf bevorzugte Ausgestaltungen der erfindungsgemäßen Logikschaltung gerichtet.

Der mit der Erfindung erzielbare Vorteil liegt insbesondere darin, daß mit dieser flankengesteuerten asynchrone Logikschaltung gegenüber einer bekannten zustandsgesteuerten Logikschaltung eine Verdopplung der Durchsatzrate erreichbar ist.

Die Erfindung wird nachfolgend anhand der Zeichnung näher erläutert. Dabei zeigt
- Figur 1: eine bereits bekannte asynchrone Logikschaltung,
- Figur 2: eine erfindungsgemäße asynchrone Logikschaltung und
- Figur 3: ein Zeitdiagramm zur Erläuterung der Funktionsweise der erfindungsgemäßen asynchronen Logikschaltung nach Figur 2.

Asynchrone oder "self timed" Schaltungen werden als zukunftsträchtiges Schaltungsprinzip für den sub-µm-Bereich angesehen, da bei der derzeitig üblichen globalen Taktansteuerung in zukünftigen hochkomplexen und äußerst schnellen Schaltungen Laufzeitprobleme (clocks skew) in der Taktversorgung auftreten, die ein entsprechendes System in seinen Abmessungen begrenzen und/oder zu einer reduzierten Verarbeitungsgeschwindigkeit führen. Bei asynchronen Schaltungen, die nach einem "handshake"-Verfahren miteinander kommunizieren, sind diese durch einen zentralen Takt bedingten Probleme ausgeschlossen.

Als Basis für solche asynchronen Schaltungen werden asynchrone Logikschaltungen benötigt, die auf ein Anfragesignal (request) hin möglichst schnell eine logische Verknüpfung durchführen und zusammen mit gültigen Daten ein Fertigmeldungssignal (ready) am Ausgang der Logikschaltung möglichst in regulärer und invertierter Form zur Verfügung stellen.

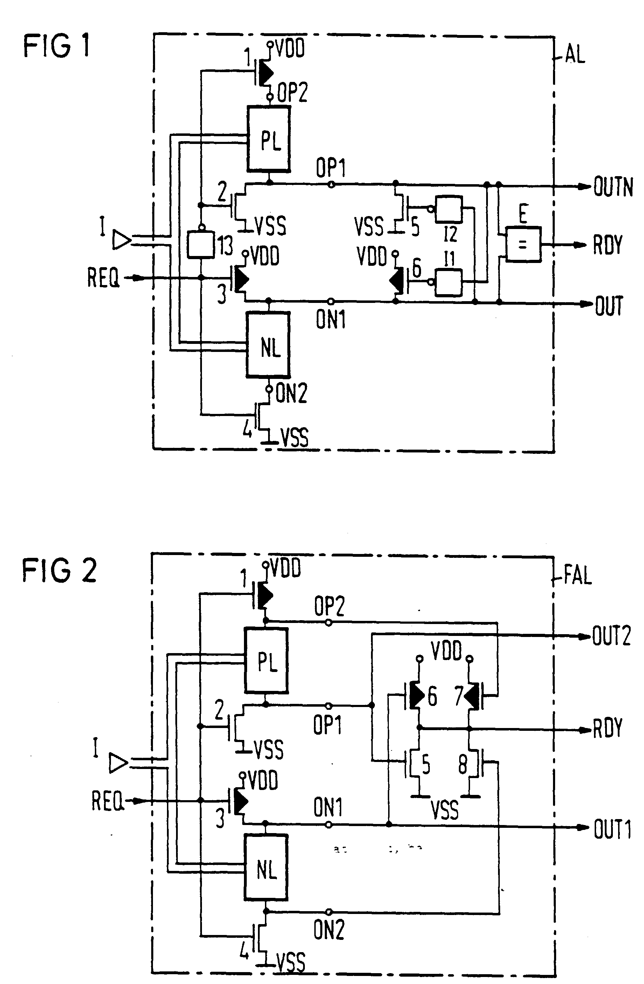

In Figur 1 ist eine bekannte asynchrone Logikschaltung AL für den 4-Phasen-Betrieb (zustandsgesteuert) gezeigt, bei der ein erster Logikblock NL aus n-Kanal-Transistoren sowie ein zweiter Logikblock PL aus p-Kanal-Transistoren besteht und der zweite Logikblock eine zum ersten Logikblock inverse Logik aufweist (Split Transistor Switch Logic). Sowohl der erste Logikblock als auch der zweite Logikblock ist mit einer Mehrzahl von Eingängen I der Logikschaltung verbunden. Der erste Logikblock NL ist an einem Ausgang ON1 über einen p-Kanal-Vorladetransistor 3 mit der Versorgungsspannung VDD und an einem Ausgang ON2 über einen n-Kanal-Ladetransistor 4 mit Bezugspotential VSS verbunden. Entsprechenderweise ist der zweite Logikblock PL an einem Ausgang OP1 über einen n-Kanal-Vorladetransistor 2 mit Bezugspotential VSS und an einem Ausgang OP2 über einen p-Kanal-Ladetransistor 1 mit der Versorgungsspannung VDD verbunden. Ein Anfrage-Eingang REQ der Logikschaltung ist direkt mit einem Gate des Vorladetransistors 3 und einem Gate des Ladetransistors 4 sowie indirekt über einen Inverter I3 mit einem Gate des Vorladetransistors 2 und dem Gate des Ladetransistors 1 verbunden. Der Ausgang ON1 bildet einen Ausgang OUT in der asynchronen Logikschaltung AL und der Ausgang OP1 stellt den dazu invertierten Ausgang OUTN der Logikschaltung AL dar. In der asynchronen Logikschaltung AL befindet sich ein weiterer n-Kanal-Vorladetransistor 5, der über einen Inverter I2 ansteuerbar ist, ein weiterer p-Kanal-Vorladetransistor 6, der über einen Inverter I1 ansteuerbar ist, und ein Äquivalenzgatter E, dessen Eingänge direkt mit den Ausgängen OP1 und ON1 der Logikschaltung AL verbunden sind. Der weitere Vorladetransistor 5 liegt parallel zum Vorladetransistor 2 und der weitere Vorladetransistor 6 liegt parallel zum Vorladetransistor 3. Der Eingang des Inverters I1 ist mit dem Ausgang OP1 und der Eingang des Inverters I2 ist mit dem Ausgang ON1 verbunden, wodurch eine gegenseitige Verkoppelung der Ausgänge OP1 und ON1 bewirkt wird. Der Ausgang der Äquivalenzschaltung E stellt gleichzeitig einen Fertigmeldungsausgang RDY der asynchronen Logikschaltung AL dar.

In Figur 2 ist eine erfindungsgemäße asynchrone Logikschaltung FAL für den 2-Phasen-Betrieb (flankengesteuert) mit zwei Ausgängen OUT1 und OUT2 dargestellt, wobei die erfindungsgemäße Logikschaltung FAL ähnlich wie die in Figur 1 gezeigte bekannte Logikschaltung AL aufgebaut ist, und einander entsprechende Schaltungselemente in beiden Figuren gleich bezeichnet sind. Ein erster Unterschied im Aufbau der erfindungsgemäßen asynchronen Logikschaltung FAL zur bekannten asynchronen Logikschaltung AL besteht darin, daß die Transistoren 1 und 2 nicht über den Inverter I3 sondern direkt durch das Signal des Anfrageeingangs REQ ansteuerbar sind. Ein weiterer Unterschied zwischen den beiden asynchronen Logikschaltungen AL und FAL besteht darin, daß die erfindungsgemäße Logikschaltung FAL keine Inverter I1 und I2 und keine Äquivalenzschaltung E besitzt sondern hierfür nur ein weiterer p-Kanal-Transistor 7 und ein weiterer n-Kanal-Transistor 8 vorgesehen ist, wobei erste Anschlüsse der Transistoren 5 und 8 mit Bezugspotential und zweite Anschlüsse dieser Transistoren mit dem Fertigmeldungsausgang RDY verbunden und erste Anschlüsse der Transistoren 6 und 7 mit dem Fertigmeldungsausgang RDY und zweite Anschlüsse dieser Transistoren 6 und 7 mit der Versorgungsspannung VDD beschaltet sind und wobei der Ausgang OP1, der gleichzeitig den Ausgang OUT2 der erfindungsgemäßen Logikschaltung FAL bildet, direkt mit dem Gate des Transistors 5, der Ausgang ON1, der gleichzeitig den Ausgang DUT1 der erfindungsgemäßen asynchronen Logikschaltung bildet, direkt mit dem Gate des Transistors 6, der Ausgang OP2 direkt mit dem Gate des Transistors 7 und der Ausgang ON2 direkt mit dem Gate des Transistors 8 verbunden ist.

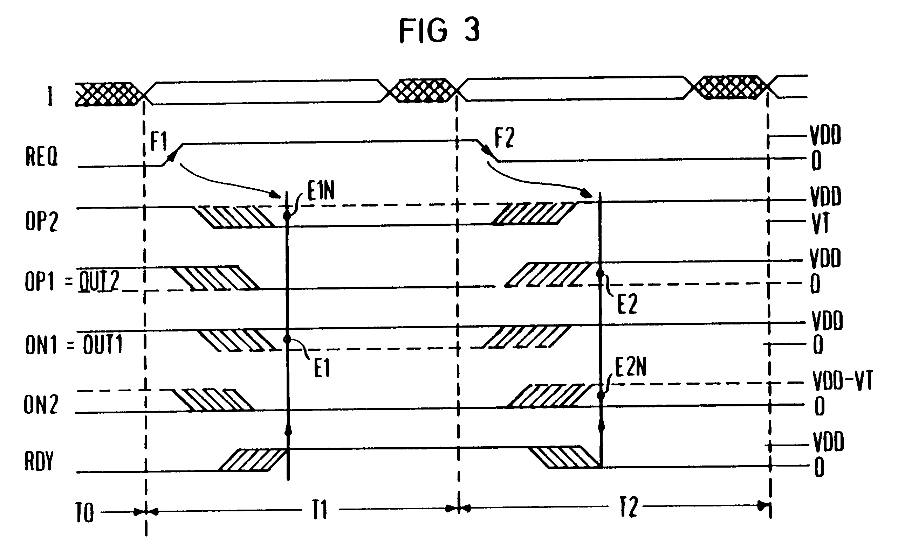

In Figur 3 sind hierzu in unmittelbar aufeinanderfolgenden Zeitbereichen T0 ... T2 die Signale der Mehrzahl von Eingängen I, das Signal am Anfrageeingang REQ, die Signale an den Ausgängen OP2, OP1, ON1 und ON2 der Logikblöcke sowie das Signal des Fertigmeldungausgangs RDY der erfindungsgemäßen Logikschaltung FAL dargestellt. Ein jeweiliger Zeitbereich beginnt dabei mit dem Vorliegen gültiger Eingangsdaten an den Eingängen I und endet mit dem Vorliegen neuer gültiger Eingangsdaten. Innerhalb des Zeitinterbereichs T0 befindet sich der Anfrageeingang REQ beispielsweise, wie hier gezeigt, auf Bezugspotential VSS, wodurch die Transistoren 1 und 3 leiten, die Transistoren 2 und 4 sperren und die Ausgänge OP2 und ON1 infolgedessen auf die Versorgungsspannung VDD vorgeladen sind und der Fertigmeldungsausgang RDY von VDD abgetrennt ist. Ist dabei beispielsweise der Logikblock PL leitend, so weist der Ausgang OP1 bzw. der Ausgang OUT2 der erfindungsgemäßen Logikschaltung FAL die Versorgungsspannung VDD auf, ist er jedoch gesperrt, so liegt am Ausgang OP1 bzw. am Ausgang OUT2 der Logikschaltung FAL Bezugspotential an. Da der Logikblock NL eine zum Logikblock PL inverse Logik besitzt, sperrt der Logikblock NL sobald der Logikblock PL leitet und es liegt Bezugspotential am Ausgang ON2 an, wenn der Ausgang OP1 VDD führt, und es liegt am Ausgang ON2 eine gestrichelt angedeutete Spannung VDD - VT an, wenn der Knoten OP1, gestrichelt angedeutet, Bezugspotential VSS führt. Die Spannung VDD - VT ist die Versorgungsspannung VDD vermindert um die Einsatzspannung VT, die aufgrund der Reihenschaltung des p-Kanal-Transistors 3 mit den n-Kanal-Transistoren des Logikblocks NL entsteht. Tritt nun innerhalb des Zeitbereichs T1 beim Signal des Anfrageeingangs REQ eine ansteigende Flanke F1 auf, so werden die Transistoren 1 und 3 sperrend, die Transistoren 2 und 4 leitend, der Ausgang OP1 bzw. der Ausgang OUT2 der erfindungsgemäßen Logikschaltung und der Ausgang ON2 werden bezüglich F1 etwas verzögert auf Bezugspotential VSS entladen. Wird beispielsweise nach einer Verarbeitung der an den Eingängen I anliegenden Eingangsdaten der Logikblock PL leitend, so findet am Ausgang OP2 ein Übergang von der Versorgungsspannung VDD auf die Einsatzspannung VT statt und beim Ausgang ON1 der erfindungsgemäßen Logikschaltung bzw. beim Ausgang OUT1, der ja aufgrund der inversen Logik sperrt, bleibt die Versorgungsspannung VDD in diesem Fall erhalten. Im gestrichelt angedeuteten anderen Fall, bei dem nach einer Verarbeitung der an den Eingängen anliegenden Eingangsdaten der Logikblock PL sperrend bleibt und der Logikblock NL leitend wird, bleibt am Ausgang OP2 die Versorgungsspannung VDD erhalten und der Ausgang ON1 bzw. der Ausgang OUT1 der erfindungsgemäßen Logikschaltung erhält Bezugspotential VSS. Da entweder der Logikblock PL oder der dazu inverse Logikblock NL leitend wird, wird entweder der Transistor 6 oder der Transistor 7 leitend, wodurch der Fertigmeldungsausgang RDY die Versorgungsspannung VDD erhält und damit ein durch F1 ausgelöstes und am Ausgang OUT1 anliegendes gültiges Verarbeitungsergebnis El signalisiert wird. Tritt dann innerhalb des Zeitbereiches T2 beim Signal des Anfangseingangs REQ eine abfallende Flanke F2 auf, so werden die Transistoren 1 und 3 wieder leitend, die Transistoren 2 und 4 wieder sperrend, die Ausgänge OP2 und ON1 bzw. der Ausgang OUT1 der erfindungsgemäßen Logikschaltung infolgedessen bezüglich F2 etwas verzögert auf die Versorgungsspannung VDD vorgeladen. Wird nun beispielsweise nach einer weiteren Verarbeitung von weiteren an den Eingängen I anliegenden weiteren Eingangsdaten der Logikblock PL leitend, so findet am Ausgang OP1 bzw. am Ausgang OUT2 der erfindungsgemäßen Logikschaltung ein Übergang vom Bezugspotential auf VDD statt und beim Knoten ON2, der aufgrund der inversen Logik sperrt, bleibt das Bezugspotential erhalten. Im gestrichelt angedeuteten anderen Fall, bei dem der Logikblock PL sperrend bleibt und der Logikblock NL leitend wird, bleibt am Ausgang OP1 bzw. am Ausgang OUT2 der erfindungsgemäßen Logikschaltung das Bezugspotential VSS erhalten und der Ausgang ON2 erhält die um die Einsatzspannung verminderte Versorgungsspannung VDD - VT. Da wiederum entweder der Logikblock PL oder dazu inverse Logikblock NL leitend wird, wird entweder der Transistor 5 oder der Transistor 8 leitend, wodurch der Fertigmeldungsausgang RDY Bezugspotential VSS erhält und damit ein durch die Flanke F2 ausgelöstes und am Ausgang OUT2 der erfindungsgemäßen Logikschaltung anliegendes gültiges weiteres Verarbeitungsergebnis E2 signalisiert wird.

## Patentansprüche

1. Asynchrone Logikschaltung (FAL),
- bei der ein erster Ausgang (OP2) eines ersten Logikblocks (PL) über einen ersten Feldeffekttransistor (1) eines ersten Leitungstyps (p) mit einem Versorgungsspannungs-anschluß (VDD) und ein zweiter Ausgang (OP1) des ersten Logikblocks (PL) über einen ersten Feldeffekttransistor (2) eines zweiten Leitungstyps (n) mit einem Bezugspotentialanschluß (VSS) verbunden sind,
- bei der ein erster Ausgang (ON1) eines zweiten Logikblocks (NL) über einen ersten Feldeffekttransistor (3) eines ersten Leitungstyps (p) mit einem Versorgungsspannungs-anschluß (VDD) und ein zweiter Ausgang (ON2) des zweiten Logikblocks (NL) über einen ersten Feldeffekttransistor (4) eines zweiten Leitungstyps (n) mit einem Bezugspotentialanschluß (VSS) verbunden sind,
- bei der der erste Logikblock (PL) nur Feldeffekttransistoren des ersten Leitungstyps (p) und der zweite Logikblock (NL) nur Feldeffektransistoren des zweiten Leitungstyps (n) enthält und beide -Logikblöcke gemeinsam mit gleichen Eingangsleitungen (I) verbunden sind,
- bei der der erste und zweite Logikblock (PL,NL) ein zueinander komplementäres Schaltverhalten aufweisen, wobei, abhängig von Steuersignalen der Eingangsleitungen (I), der erste Ausgang (OP2) des ersten Logikblocks (PL) genau dann auf den zweiten Ausgang (OP1) des ersten Logikblocks (PL) durchgeschaltet ist, wenn der erste Ausgang (ON1) des zweiten Logikblocks (NL) auf den zweiten Ausgang (ON2) des zweiten Logikblocks (NL) gerade nicht durchgeschaltet ist und umgekehrt.

2. Logikschaltung nach Anspruch 1, **dadurch gekennzeichnet**, daß der erste Logikblock (NL) nur aus n-Kanal-Feldeffekttransistoren und der zweite Logikblock (PL) nur aus p-Kanal-Feldeffekttransistoren aufgebaut ist.

3. Logikschaltung nach Anspruch 1, **dadurch gekennzeichnet**, daß der erste Logikblock (NL) nur aus p-Kanal-Feldeffekttransistoren und der zweite Logikblock (PL) nur aus n-Kanal-Feldeffekttransistoren aufgebaut ist.

## Claims

1. Asynchronous logic circuit (FAL),
- in which a first output (OP2) of a first logic block (PL) is connected via a first field-effect transistor (1) of a first conduction type (p) to a supply voltage terminal (VDD) and a second output (OP1) of the first logic block (PL) is connected via a first field-effect transistor (2) of a second conduction type (n) to a reference potential terminal (VSS),
- in which a first output (ON1) of a second logic block (NL) is connected via a first field-effect transistor (3) of a first conduction type (p) to a supply voltage terminal (VDD) and a second output (ON2) of the second logic block (NL) is connected via a first field-effect transistor (4) of a second conduction type (n) to a reference potential terminal (VSS),
- in which the first logic block (PL) contains only field-effect transistors of the first conduction type (p) and the second logic block (NL) contains only field-effect transistors of the second conduction type (n) and both logic blocks together are connected to identical input lines (I),
- in which the first and second logic block (PL, NL) have a switching behaviour which is complementary to one another, the first output (OP2) of the first logic block (PL) being switched through, as a function of control signals of the input lines (I), to the second output (OP1) of the first logic block (PL) precisely when the first output (ON1) of the second logic block (NL) is not switched through to the second output (ON2) of the second logic block (NL), and vice versa,
- in which the respective gate of the first field-effect transistor (1) of the first conduction type (p), of the first field-effect transistor (2) of the second conduction type (n), of the second field-effect transistor (3) of the first conduction type (p) and of the second field-effect transistor (4) of the second conduction type (n) is connected to an request input (REQ),
- in which a ready-message output (RDY) is connected via a third and a fourth field-effect transistor (6, 7) of the first conduction type (p) to the supply voltage terminal (VDD), the gate of the third field-effect transistor (6) of the first conduction type (p) being connected to the first output (ON1) of the second logic block (NL) and the gate of the fourth field-effect transistor (7) of the first conduction type (p) being connected to the first output (OP2) of the first logic block (PL),
- in which the ready-message output (RDY) is connected via a third and a fourth field-effect transistor (5, 8) of the second conduction type (n) to the reference potential terminal (VDD), the gate of the third field-effect transistor (5) of the second conduction type (n) being connected to the second output (OP1) of the first logic block (PL) and the gate of the fourth field-effect transistor (8) of the second conduction type (n) being connected to the second output (ON2) of the second logic block (NL), and
- in which outputs (OP1, ON1) of the two logic blocks simultaneously constitute outputs (OUT1, OUT2) of the asynchronous logic circuit (FAL).

2. Logic circuit according to Claim 1, characterized in that the first logic block (NL) is composed of n-channel field-effect transistors exclusively and the second logic block (PL) is composed of p-channel field-effect transistors exclusively.

3. Logic circuit according to Claim 1, characterized in that the first logic block (NL) is composed of p-channel field-effect transistors exclusively and the second logic block (PL) is composed of n-channel field-effect transistors exclusively.

## Revendications

1. Circuit logique asynchrone (FAL),
- dans lequel une première sortie (OP2) d'un premier bloc logique (PL) est reliée, au moyen d'un premier transistor à effet de champ (1) d'une première nature de conductivité (p), à un premier raccordement de tension d'alimentation (VDD) et une deuxième sortie (OP1) du premier bloc logique (PL) est reliée, au moyen d'un premier transistor à effet de champ (2) d'une deuxième nature de conductivité (n), à un raccordement de potentiel de référence (VSS),
- dans lequel une première sortie (ON1) d'un deuxième bloc logique (NL) est reliée, au moyen d'un premier transistor à effet de champ (3) d'une première nature de conductivité (p), à un raccordement de tension d'alimentation (VDD) et une deuxième sortie (ON2) du deuxième bloc logique (NL) est reliée, au moyen d'un premier transistor à effet de champ (4) d'une deuxième nature de conductivité (n) à un raccordement de potentiel de référence (VSS),
- dans lequel le premier bloc logique (PL) contient uniquement des transistors à effet de champ de la première nature de conductivité (p) et le deuxième bloc logique (NL) contient uniquement des transistors à effet de champ de la deuxième nature de conductivité (n) et les deux blocs logiques sont reliés ensemble avec les mêmes lignes d'entrée (I),
- dans lequel le premier et le deuxième bloc logique (PL, NL) présentent un comportement en commutation complémentaire l'un à l'autre, dans lequel, en fonction des signaux de commande des lignes d'entrée (I), la première sortie (OP2) du premier bloc logique (PL) est interconnectée à la deuxième sortie (OP1) du premier bloc logique (PL) seulement dans le cas où la première sortie (ON1) du deuxième bloc logique (NL) n'est justement pas interconnectée à la deuxième sortie (ON2) du deuxième bloc logique (NL) et inversement,
- dans lequel les grilles respectives du premier transistor à effet de champ (1) du premier type de conductivité (p), du premier transistor à effet de champ (2) du deuxième type de conductivité (n), du deuxième transistor à effet de champ (3) du premier type de conductivité (p) et du deuxième transistor à effet de champ (4) du deuxième type de conductivité (n) sont reliées à une entrée-demande (REQ),
- dans lequel une sortie de signal d'achèvement (RDY) est reliée au raccordement de tension d'alimentation (VDD) par l'intermédiaire d'un troisième et d'un quatrième transistor à effet de champ (6, 7) du premier type de conductivité (p), la grille du troisième transistor à effet de champ (6) du premier type de conductivité (p) étant reliée à la première sortie (ON1) du deuxième bloc logique (NL) et la grille du quatrième transistor à effet de champ (7) du premier type de conductivité (p) étant reliée à la première sortie (OP2) du premier bloc logique (PL),
- dans lequel la sortie de signal d'achèvement (RDY) est reliée au raccordement de potentiel de référence (VSS) par l'intermédiaire d'un troisième et d'un quatrième transistor à effet de champ (5, 8) du deuxième type de conductivité (n), la grille du troisième transistor à effet de champ (5) du deuxième type de conductivité (n) étant reliée à la deuxième sortie (OP1) du premier bloc logique (PL) et la grille du quatrième transistor à effet de champ (8) du deuxième type de conductivité (n) étant reliée à la deuxième sortie (ON2) du deuxième bloc logique (NL), et
- dans lequel des sorties (OP1, ON1) des deux blocs logiques représentent en même temps des sorties (OUT1, OUT2) du circuit logique asynchrone (FAL).

2. Circuit logique selon la revendication 1, caractérisé en ce que le premier bloc logique (NL) est uniquement constitué de transistors à effet de champ à canal N et le deuxième bloc logique (PL) est uniquement constitué de transistors à effet de champ à canal P.

3. Circuit logique selon la revendication 1, caractérisé en ce que le premier bloc logique (NL) est constitué uniquement de transistors à effet de champ à canal P et le deuxième bloc logique (PL) est constitué uniquement de transistors à effet de champ à canal N.
